# EUROPÄISCHE PATENTSCHRIFT

(11) **EP 2 159 935 B1**
(45) Veröffentlichungstag und Bekanntmachung des Hinweises auf die Patenterteilung: **03.09.2014**
(21) Anmeldenummer: 09164987.1
(22) Anmeldetag: 09.07.2009
(51) Int. Cl.: H04B 10/80

(54) **Opto-elektronische Vorrichtung mit einer eingebauten Sicherungsvorrichtung**
Optoelectronic device with a built-in safety device
Dispositif optoélectronique doté d'un dispositif de sécurisation encastré

(30) Priorität: 01.09.2008 DE 102008045139
(43) Veröffentlichungstag der Anmeldung: 03.03.2010
(73) Patentinhaber: Endress + Hauser Flowtec AG, 4153 Reinach (CH)
(72) Erfinder: Keita, Mamadi, 4053, Basel (CH); Simon, Antoine, 68300, St. Louis (FR)
(74) Vertreter: Andres, Angelika Maria

(56) Entgegenhaltungen:
- WO-A2-2008/048384
- DE-A1- 3 737 445
- US-A- 4 924 343
- US-A1- 2006 242 350
- WOERTZ AG: "OPTOCOUPLER MODULES" INTERNET CITATION, [Online] 1. September 2002 (2002-09-01), Seite 20pp, XP007910732 Gefunden im Internet: URL:http://www.woertz-usa.com/electronics% 20opto%2026_e.pdf> [gefunden am 2009-11-30]

## Beschreibung

Die Erfindung bezieht sich auf eine opto-elektronische Vorrichtung zur Übertragung eines elektrischen Signals von einem Eingangsstromkreis an einen galvanisch von dem Eingangsstromkreis getrennten Ausgangsstromkreis, mit einem Gehäuse, wobei der Eingangsstromkreis eine optische Sendeeinheit zur Erzeugung eines optischen Signals enthält, welche in dem Gehäuse angeordnet ist, wobei der Ausgangsstromkreis eine optische Empfangseinheit zum Empfangen des optischen Signals aufweist, welche in dem Gehäuse angeordnet ist.

Zudem bezieht sich die Erfindung auf ein Messgerät der Prozessautomatisierungstechnik zur Bestimmung und/oder Überwachung einer chemischen und/oder physikalischen Messgröße.

Opto-elektronische Vorrichtungen mit einer optischen Sendeeinheit und einer optischen Empfangseinheit werden beispielsweise zur digitalen und/oder analogen Signalübertragung zwischen zwei voneinander galvanisch getrennten Stromkreisen verwendet.

In der industriellen Messtechnik, insb. in der Automatisierungs- und Prozesssteuerungstechnik, werden solche opto-elektronischen Vorrichtungen in Feldgeräten zur galvanischen Trennung der Stromkreise aufgrund des Explosionsschutzes eingesetzt und gefordert. Die entsprechenden Feldgeräte ermitteln beispielsweise den Druck, den Durchfluss, den Füllstand, die Dielektrizitätskonstante, die Grenzschicht, die Temperatur oder eine andersartige physikalische und/oder chemische Prozessgröße als eine Prozessvariable in einem Prozessablauf. Von der Anmelderin werden beispielsweise Feldgeräte unter dem Namen Cerabar, Deltabar, Deltapilot, Promass, Levelflex, Micropilot, Prosonic, Soliphant, Liquiphant, Easytemp produziert und vertrieben, die vorwiegend dazu bestimmt sind, zumindest eine der oben bezeichneten Prozessvariablen eines Mediums zu bestimmen und/oder zu überwachen.

Die galvanische Trennung wird sowohl bei so genannten Zweileitergeräten, welche die Versorgungsenergie und das Messsignal über ein gemeinsames Leitungspaar übermitteln, als auch bei Vierleitergeräten, die jeweils ein separates Leitungspaar zur Übermittlung des Messsignals und der Versorgungsenergie aufweisen, eingesetzt, Beispiele für derartige Feldgeräte mit einer solchen als Optokoppler für galvanisch getrennte Stromkreise ausgebildeten Vorrichtung sind in der US 4,654,771 A und der WO 2004/048905 A1 beschrieben.

Die hauptsächlich als Optokoppler verwendeten opto-elektronischen Vorrichtungen sind beispielsweise in der DE 199 20 403 A1 und der US 6,947,620 B2 beschrieben. Allgemein bestehen solche opto-elektronischen Vorrichtungen aus zumindest einem Sendeelement, z.B. einer Leuchtdiode, und zumindest einem Empfangselement, z.B. einer Photodiode oder einem Phototransistor, die zumindest über ein lichtleitendes Element räumlich und galvanisch voneinander getrennt sind.

Damit solche für die Signalübertragung verwendeten opto-elektronischen Vorrichtungen dem in der industriellen Mess- und Automatisierungstechnik geforderten Explosionsschutz genügen, sind von diesen auch die für zwischen galvanisch getrennten stromführenden Komponenten geforderke Mindestabstände für Luftstrecken, Isolationsdicken und Stromkriechpfade geforderte Mindestwerte einzuhalten. Die Ex-i Norm IEC60079-11 fordert zum Beispiel, bei einer Spannung von 375 V eine minimale Kriechpfadlänge von 10 mm oder einen minimalen Abstand von 2 mm unter Verguss, oder einen minimalen Abstand von 1 mm unter fester Isolation. Diese Abstände beziehen sich dabei im Besonderen auf die minimalen Abstände zwischen den im Betriebsfall elektrischen Strom führenden Anschlüssen und Leiterbahnen der mittels solcher opto-elektronischen Vorrichtungen gekoppelten Stromkreise. Des Weiteren sind seitens solcher Optokoppler erhöhte Anforderungen, auch hinsichtlich der Temperaturbeständigkeit und des Explosionsgefährdungsrisikos, sowie auch hinsichtlich der bei eintretenden Überbelastungen auftretenden Schäden, zu erfüllen.

Um trotz der hohen sicherheitstechnischen Anforderungen einen möglichst hohen Kopplungsfaktor (CTR, current transfer ratio) sowie eine möglichst kompakte Bauform solcher opto-elektronischen Vorrichtungen zu ermöglichen, sind deren lichtleitende Elemente den Anforderungen aus dem Explosionsschutz und der Signalübertragung entsprechend ausgebildet.

Die aus dem Stand der Technik bekannten Lösungen schwächen entweder das übertragene Lichtsignal, da die optischen Komponenten z.B. weiter von einander entfernt sind oder es ist eine zusätzliche elektrische oder elektronische Schaltung nötig, die den Stromfluss in der opto-elektronischen Vorrichtung bis auf den maximal angegebenen zulässigen Stromstärkewert, welcher bspw. durch ein Sicherheitszertifikat vorgegeben ist, beschränkt. Diese Lösungen haben jedoch einen erhöhten Platzbedarf und erfordern das Aufbringen zusätzlicher elektrischer oder elektronischer Bauteile auf die Elektronikplatine, Will man auf diese zusätzlicher Bausteile verzichten, darf kein maximal zulässiger Stromstärkewert der bspw. in einem Datenblatt oder in dem Sicherheitszertifikat angegeben ist, überschritten werden. In diesem Fall, muss aber damit gerechnet werden, dass die opto-elektronische Vorrichtung in Fehlsituation mit theoretisch unbegrenztem Strom überlastet werden kann. Diese Überlast kann natürlich die opto-elektronische Vorrichtung beschädigen. Nach der Überlast muss aber entsprechend einer Ex-i Norm immer noch ein minimaler Isolationsgrad, gewährleistet sein.

Bei den heute üblichen Halbleiter-Bauelementen in Gehäusen mit harter Vergussmasse führt eine extreme Überlastung im Allgemeinen zu einem explosionsartigen Platzen des Gehäuses und damit zu einer Drahtverbindung-/Stromkreis-Unterbrechung. Ein solches ungesteuertes Platzen des Gehäuses kann zu schadhaften Folgen, nicht nur für das Messgerät, sondern auch in der Umgebung des Messgerätes führen.

Aus den Patentanmeldungen EP0434489, US4107762, US4814946, US6411498 sind Kondensatoren mit eingebetteten Schmelzsicherungen bekannt geworden, um im Falle eines Defekts, bspw. bei einem Kurzschluss zwischen den Elektroden des Kondensators, den Stromfluss zu unterbrechen. Elektrische Bauteile wie Kondensatoren sind aber nicht oder nur ungenügend zur Übertragung von Signalen insbesondere bei galvanischer Trennung geeignet, da sie Frequenzabhängig sind. Zudem lässt sich durch Kondensatoren kein hoher Isolationsgrad zwischen den elektrisch zu trennenden Stromkreisen erreichen.

Ein Optokoppler gemäss dem Stand der Technik ist ausserdem aus dem Datenblatt der Firma Woerz AG bekannt, ("Optocoupler Modules" aus 2002), vgl. Modulnummer 46148C1.

Der Erfindung liegt die Aufgabe zugrunde eine explosionssichere optoelektronische Vorrichtung mit definierter Sicherungscharakteristik vorzuschlagen.

Die Erfindung wird durch eine opto-elektronische Vorrichtung mit einem Gehäuse und durch die Verwendung einer erfindungsgemäßen opto-elektronischen Vorrichtung in einem Messgerät der Prozessautomatisierungstechnik gelöst.

Die Aufgabe wird hinsichtlich der opto-elektronischen Vorrichtung mit einem Gehäuse erfindungsgemäß dadurch gelöst, dass mindestens eine Sicherungsvorrichtung in dem Gehäuse vorgesehen ist, welche die Übertragung des elektrischen Signals im Falle eines Stromflusses, der über einem vorgegebenen Stromstärkewert liegt, unterbricht. Das Gehäuse, in dem die Bauteile angeordnet sind, besteht vollständig aus der Vergussmasse. Von Vorteil ist die sich aus der vorgeschlagenen Ausführungsform ergebende kompakte Bauweise der opto-elektronischen Vorrichtung und die daraus resultierende Material- sowie Platzersparnis. Ferner sind wenigstens zwei elektrische Anschlüsse an dem Gehäuse zur Herstellung einer ersten elektrischen Verbindung mit dem Eingangsstromkreis vorgesehen und wenigstens zwei weitere elektrische Anschlüsse sind an dem Gehäuse zur Herstellung einer zweiten elektrischen Verbindung mit dem Ausgangsstromkreis vorgesehen. Über die vorgesehenen Anschlüsse ist die in dem Gehäuse angeordnete opto-elektronische Vorrichtung kontaktierbar.

Vorzugsweise ist die Sicherungsvorrichtung dabei so ausgelegt, dass sie bei einer Stromstärke auslöst, die unterhalb der Stromstärke liegt, bei der Gefahr besteht, dass entweder die optische Sendeeinheit oder die optische Empfangseinheit explodiert. Eine Explosion lässt sich nicht unbedingt vermeiden. Erfindungsgemäß wird der dadurch entstandene Schaden so begrenzt, dass Sendeeinheit und Empfangseinheit nicht gleichzeitig vom Gehäuseplastik nicht geschützt bleiben. Von Vorteil bei der Verwendung einer in die opto-elektrische Vorrichtung Integrierten Sicherungsvorrichtung ist, dass eine Sicherungsvorrichtung weniger Energie akkumuliert als eine bspw. aus einem Halbeleitermaterial bzw. einer Halbleiterschaltung bestehende optische Empfangs- oder Sendeeinheit. Dadurch, dass eine geringere Energiemenge zur Auslösung der Sicherungsvorrichtung im Vergleich zu der Energiemenge, die in der optischen Sende- oder Empfangseinheit gespeichert werden kann, nötig ist, kommt es auch zu einer geringeren Explosionssprengkraft im Falle einer Überbelastung. Erfindungsgemäß kann somit auf einfache Weise und ohne weitere externe Bauteile eine den Normen der Explosionssicherheit genügende opto-elektronische Vorrichtung verwirklicht werden. Der vorgegebene Stromstärkewert liegt dabei unterhalb dem Stromstärkewert der zu einer Explosion, vorzugsweise unter dem Wert der zu einer Beschädigung, der optischen Sendeeinheit oder optischen Empfangseinheit führt

In einer vorteilhaften Weiterbildung unterbricht die Sicherungsvorrichtung den Eingangsstromkreis oder den Ausgangsstromkreis im Falle eines Stromflusses, der über einem vorgegebenen Stromstärkewert liegt. Vorzugsweise unterbricht die Sicherungsvorrichtung den Eingangs- oder Ausgangstromkreis bevor es zu einer Explosion der optischen Sende- oder Empfangseinheit infolge der Überlast kommt. Von Vorteil ist, die besonders kostengünstige sowie Platz sparende Realisierbarkeit bspw. in Form einer Schmelzsicherung oder eines Schalters, der den Eingangs- und/oder Ausgangsstromkreis unterbricht und damit die Signalübertragung von der optischen Sendeeinheit zur optischen Empfangseinheit beendet. Vorteilhafterweise unterbricht die Sicherungsvorrichtung bspw. nur den Teil des Eingangs- oder Ausgangsstromkreises, welcher die optischen Sendeeinheit bzw. die optischen Empfangseinheit enthält.

In einer vorteilhaften Ausgestaltung handelt es sich bei der Sicherungsvorrichtung um eine elektrische, elektronische oder thermische Sicherungsvorrichtung. Diese Sicherungen sind bereits handelsüblich und daher kostengünstig erhältlich.

In einer weiteren vorteilhaften Ausgestaltung sind die optische Sendeeinheit, die optische Empfangseinheit und/oder die Sicherungsvorrichtung wenigstens teilweise in eine Vergussmasse eingebettet. Um den Anforderungen der Normen zum Explosionsschutz zu entsprechen, wird dafür ein geeignetes Material und eine geeignete Schichtdicke der Vergussmasse gewählt werden. Die zusätzliche Einbettung der Bauteile sorgt für eine isolierende Beschichtung. Dadurch sind die Bauteile elektrisch isoliert und unter betriebsgemäßen Bedingungen ausreichend geschützt.

In einer bevorzugten Ausführungsform ist die Sicherungsvorrichtung so ausgelegt und auf das Gehäuse und/oder die Vergussmasse abgestimmt, dass im Fall einer etwaigen, durch das Auslösen der Sicherungsvorrichtung verursachten Beschädigung des Gehäuses und/oder der Vergussmasse, die optische Sendeeinheit oder die optische Empfangseinheit dennoch wenigstens teilweise von dem Gehäuse umgeben ist und/oder in der Vergussmasse eingebettet ist. Durch eine geeignete Abstimmung der Sicherungsvorrichtung auf das Gehäuse bzw. die Vergussmasse lassen sich Beschädigungen bedingt durch eine Überlast und das Auslösen der Sicherungsvorrichtung verhindern oder zumindest reduzieren.

In einer vorteilhaften Ausführungsform ist das Gehäuse dabei in verschiedene Gehäuseabschnitte unterteilt, die bspw. die Sendeeinheit und/oder die Empfangseinheit oder die Sicherungsvorrichtung enthalten. Diese Gehäuseabschnitte können bspw. mittels einer Sollbruchstelle miteinander verbunden sein.

Sicherheitsrelevante Beschädigungen der opto-elektronischen Vorrichtung können bspw. durch destruktive mechanische Effekte infolge einer Überlast entstehen. Aufgrund der Überlast kann es zu Explosionen, insbesondere im Bereich, in dem die Sicherungsvorrichtung angeordnet ist, kommen, welche Teile des Gehäuses und/oder der Vergussmasse absprengen. Insbesondere das Gehäuse und die aus der Vergussmasse bestehende Verkleidung der optischen Sende- oder Empfangseinheit können dabei abplatzen.

Indem das Auslöseverhalten der Sicherungsvorrichtung geeignet auf das Material und die Schichtdicke des Gehäuses und/oder der Vergussmasse abgestimmt wird, lassen sich diese Beschädigungen reduzieren und die opto-elektronische Vorrichtung explosionssicher entsprechend einer Ex-Norm ausgestalten.

In einer weiteren Ausführungsform weist die Sicherungsvorrichtung einen solchen Abstand zur optischen Sendeeinheit und/oder zur optischen Empfangseinheit auf, dass im Fall einer etwaigen durch das Auslösen der Sicherungsvorrichtung verursachten Beschädigung des Gehäuses oder der Vergussmasse, die optische Sendeeinheit oder die optische Empfangseinheit dennoch wenigstens teilweise von dem Gehäuse umgeben und/oder in der Vergussmasse eingebettet ist. Ein Vorteil der vorgeschlagenen Ausführungsform ist, dass die in dem Gehäuse eingebaute, betriebsgemäß stromführende und stromspeichernde optische Sende- und Empfangseinheit nicht gleichzeitig bzw. nicht vollständig ohne isolierende Verkleidung sind, und die die opto-elektronische Vorrichtung selbst im Falle eines Defekts ihre isolierende Wirkung beibehält. Bevorzugt ist die Sicherungsvorrichtung nicht in die optische Sendeeinheit oder Empfangseinheit integriert und nicht unmittelbar, sondern wenigstens über elektrische Verbindungsleitungen, mit der optischen Sende- oder Empfangseinheit verbunden. Dadurch wirken die destruktiven Effekte einer Überlast wie bspw. eine Explosion der Sicherungsvorrichtung, nicht primär in dem Gehäuseabschnitt, in dem die Sende- und/oder Empfangseinheit angeordnet sind.

Vorzugszugsweise ist die Sicherungsvorrichtung in einem von der optischen Sende- oder Empfangseinheit entfernten Gehäuseabschnitt angeordnet. Der konkrete Abstand zwischen der Sicherungsvorrichtung und der optischen Sende- oder Empfangseinheit ist dabei Auslegungssache und hängt von den verwendeten Materialien und der Anordnung der Bauteile ab.

In einer weiteren Ausgestaltung enthält der Eingangstromkreis mindestens eine erste Sicherungsvorrichtung, welche in dem Gehäuse angeordnet ist, und der Ausgangsstromkreis enthält mindestens eine zweite Sicherungsvorrichtung, welche in dem Gehäuse angeordnet ist. Dadurch kann die opto-elektronische Vorrichtung bspw. als Optokoppler verwendet werden und entsprechend den Bestimmungen der EN 50020:2002 IEC 60079-11, FM Class 3610:1999 und/oder CSA No. 157-92 kostengünstig und sicher ausgestaltet werden.

In einer Weiterbildung ist die erste Sicherungsvorrichtung in Reihe zu der optischen Sendeeinheit angeordnet und/oder die zweite Sicherungsvorrichtung ist in Reihe zu der optischen Empfangseinheit angeordnet. Dadurch wird die Übertragung des elektrischen Signals von dem Eingangsstromkreis an den Ausgangsstromkreis gezielt unterbrochen, ohne dass andere bspw. parallel zu der optischen Sende- oder Empfangseinheit angeordnete Bauteile von der Stromversorgung abgeschnitten werden.

In einer Fortbildung weist die erste Sicherungsvorrichtung einen Abstand zu der zweiten Sicherungsvorrichtung auf, der größer ist als der Abstand der optischen Sendeeinheit zur optischen Empfangseinheit. Im Falle von blanken Drähten, Verbindungsleitungen oder anderen stromführenden oder stromspeichemden Elementen im Bereich der ersten oder zweiten Sicherungsvorrichtung infolge einer Explosion der ersten oder zweiten Sicherungsvorrichtung wird der Übersprung von Funken durch den im Vergleich zum Abstand zwischen der optischen Sendeeinheit und der optischen Empfangseinheit größeren Abstand der ersten Sicherungsvorrichtung zur zweiten Sicherungsvorrichtung verhindert.

Hinsichtlich des Messgeräts wird die Aufgabe erfindungsgemäß dadurch gelöst, dass ein Messgerät mit einer opto-elektronischen Vorrichtung gemäß wenigstens einer der oben genannten Ausführungsformen verwendet wird. Die erfindungsgemäße opto-elektronische Vorrichtung erfüllt die an ein Messgerät hinsichtlich Explosionssicherheit gestellten Anforderungen in einem hohen Maß und ermöglicht eine durch das Einsparen von externen Bauteilen kostengünstige und zugleich Platz sparende Anordnung einer Mess- und Betriebselektronik in dem Messgerät.

Die Erfindung wird anhand der nachfolgenden Zeichnungen näher erläutert. Es zeigt:
Fig. 1: ein Anwendungsbeispiel eines aus dem Stand der Technik bekannten Optokopplers,
Fig. 2: eine schematische Darstellung einer ersten Ausführungsform einer erfindungsgemäßen opto-elektronischen Vorrichtung,
Fig. 3: eine schematische Darstellung einer zweiten Ausführungsform einer erfindungsgemäßen opto-elektronischen Vorrichtung, und

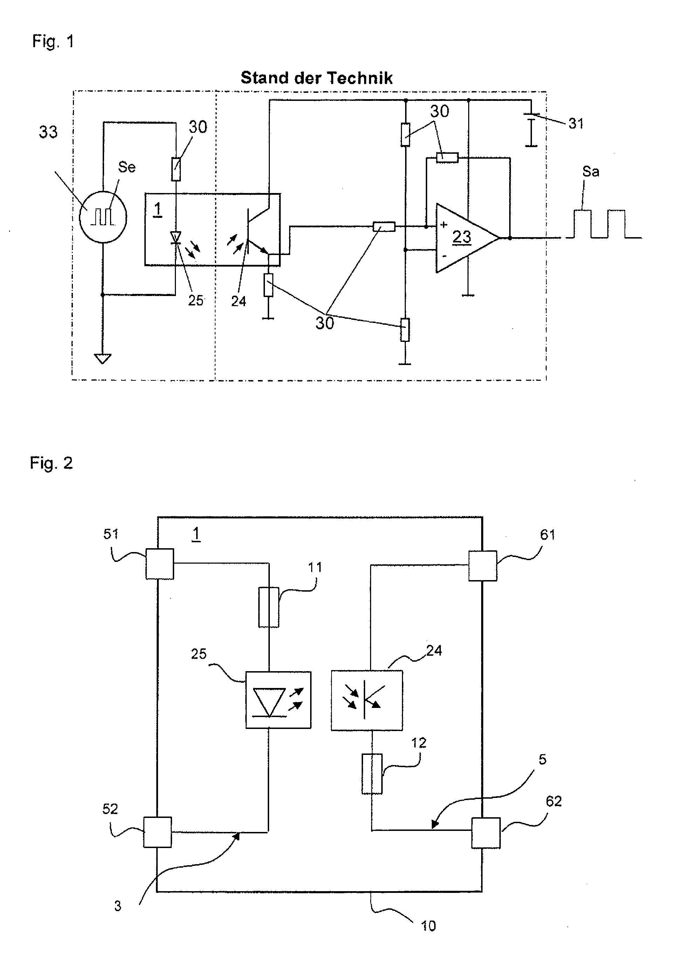

In Figur 1 ist ein Anwendungsbeispiel einer opto-elektronischen Vorrichtung 1 gezeigt. Die Vorrichtung dient dabei als Optokoppler zur Übertragung eines Wechselspannungssignals Se. Der gezeigte Optokoppler ist bereits aus dem Stand der Technik bspw. aus der Patentanmeldung DE 102006062599 A1 bekannt. An den Eingansstromkreis 3 ist ein einen Signalgenerator 33 angeschlossen, der über einen Widerstand 30 begrenzt eine Leuchtdiode 25 als Sendeeinheit 4 speist. Die Leuchtdiode 25 sendet entsprechend dem Signal Se des Signalgenerators ein Lichtsignal zu der Empfangseinheit 6 im Ausgangsstromkreis 5. An den Ausgangsstromkreis 5 ist ein Phototransistor 24 als Empfangseinheit 6 angeschlossen, dessen Ausgangssignal Sa durch eine nichtinvertierende Operationsverstärkerschaltung verstärkt wird. Die nichtinvertierende Operationsverstärkerschaltung besteht aus einem Operationsverstärker 23 und mehreren Widerständen 30 zur Einstellung der Verstärkung.

Figur 2 zeigt eine schematische Darstellung einer erfindungsgemäßen opto-elektronischen Vorrichtung 1. Die Vorrichtung 1 ist dabei umgebungsseitig von einem Gehäuse 10 begrenzt. Das Gehäuse 10 besteht dabei aus einer Vergussmasse, in welche die Sicherungsvorrichtung 11, 12, die optische Sendeeinheit und die optische Empfangseinheit eingebettet sind. Der Eingangsstromkreis ist über die Kontakte 51, 52 elektrisch kontaktierbar. Die optische Sendeinheit in Form einer Leuchtdiode 25 und die optische Empfangseinheit in Form eines Phototransistors 24 sind mittig in dem Gehäuse 10 angeordnet. Der Ausgangstromkreis 5 enthält einen Phototransistor 24 und ist über die Kontakte 61, 62 elektrisch kontaktierbar. Die Leuchtdiode 25 überträgt ein optisches Signal an den der Leuchtdiode 25 gegenüberliegenden Phototransistor 24.

Innerhalb des Gehäuses 10 sind elektrische Verbindungsleitungen vorgesehen, über welche die optische Sendeinheit bzw. die optische Empfangseinheit mit den Kontakten 51, 52 bzw. 61, 62 elektrisch verbunden ist. Der Eingangsstromkreis 3 enthält eine erste Sicherungsvorrichtung in Form einer Schmelzsicherung 11, die im Fall eines Überstroms den Eingangsstromkreis 3 unterbricht. Die Stromstärke bei der die Schmelzsicherung 11 auslöst, ist kleiner, als die Stromstärke, die zu einer Explosion der optischen Sendeeinheit führt. Die Schmelzsicherung ist dabei in Reihe vor der optischen Sendeeinheit angeordnet.

Besteht der Eingangsstromkreis 3 oder der Ausgangsstromkreis 5 der opto-elektronische Vorrichtung 1 aus mehreren evt. parallel verlaufenden Verbindungsleitungen, so ist die Sicherungsvorrichtung 11, 12 bspw. so angeordnet, dass sie nur den Stromfluss durch die opto-elektronische Sendeeinheit bzw. Empfangseinheit unterbricht und dadurch auch die Übertragung des optischen Signals von der optischen Sendeinheit zur optischen Empfangseinheit beendet.

Zwischen dem Phototransistor 24 und dem Kontakt 62 ist in den Ausgangstromkreis 5 eine zweite Sicherungsvorrichtung ebenfalls in Form einer Schmelzsicherung 12 eingebracht. Die zweite Sicherungsvorrichtung ist dabei analog zur ersten Sicherungsvorrichtung ausgelegt.

Anstelle des Phototransistors 24 kann in diesem Ausführungsbeispiel auch eine Photodiode als optische Empfangseinheit dienen.

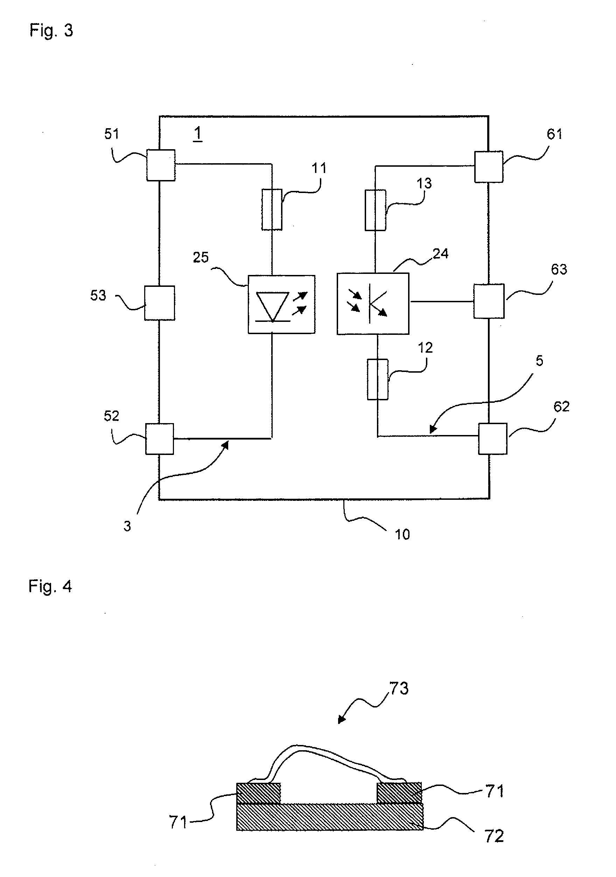

Figur 3 zeigt eine zweite Ausführungsform der erfindungsgemäßen opto-elektronischen Vorrichtung 1. In diesem Ausführungsbeispiel ist die optische Empfangseinheit ein Phototransistor 24 mit drei elektrischen Kontakten 61, 62, 63. Der Kontakt 61 ist mit dem Kollektor-Anschluss und der Kontakt 62 mit dem Emitter-Anschluss des Phototransistors verbunden. Über den Kontakt 63 ist die Basis des Phototransistors 24 anschließbar, um den Arbeitspunkt des Phototransistors 24 zu steuern oder zu regeln. Um den Ausgangsstromkreis 5 gegenüber einem Überstrom oder einer Überspannung abzusichern, sind zwischen dem Phototransistor 24 und den Kontakten 61, 62 Sicherungsvorrichtungen in Form von Schmelzsicherungen 12, 13 vorgesehen. Die Schmelzsicherungen 12, 13 weisen verschiedene auf den Stromfluss zwischen dem Kontakt 61 und dem Kollektor-Anschluss des Phototransistors 24 und den Stromfluss zwischen dem Emitter-Anschluss und dem Kontakt 62 abgestimmte Auslösecharakteristika auf.

Der Kontakt 53 dient im gezeigten Ausführungsbeispiel lediglich der zusätzlichen Verankerung der opto-elektronischen Vorrichtung 1 auf bspw. einer Elektronikplatine.

### Bezugszeichenliste

- 1: Opto-elektronische Vorrichtung
- 3: Eingangsstromkreis
- 5: Ausgangsstromkreis
- 10: Gehäuse
- 11: Schmelzsicherung
- 12: Schmelzsicherung
- 13: Schmelzsicherung
- 23: OPV
- 24: Phototransistor
- 25: Leuchtdiode
- 30: Widerstand
- 31: Spannungsversorgung
- 33: Signalgenerator
- 51: elektrischer Kontakt
- 52: elektrischer Kontakt
- 53: elektrischer Kontakt
- 61: elektrischer Kontakt
- 62: elektrischer Kontakt
- 63: elektrischer Kontakt
- 71: elektrischer Kontakt
- 72: Trägerelement
- 73: Drahtverbindung

- Sa: Ausgangssignal
- Se: Eingangssignal

## Patentansprüche

1. Opto-elektronische Vorrichtung (1) zur Übertragung eines elektrischen Signals von einem Eingangsstromkreis (3) an einen galvanisch von dem Eingangsstromkreis (3) getrennten Ausgangsstromkreis (5),
mit einem Gehäuse (10),
wobei der Eingangsstromkreis (3) eine optische Sendeeinheit (25) zur Erzeugung eines optischen Signals enthält, welche in dem Gehäuse (10) angeordnet ist,
wobei der Ausgangsstromkreis (5) eine optische Empfangseinheit (24) zum Empfangen des optischen Signals enthält, welche in dem Gehäuse (10) angeordnet ist,
wobei mindestens eine Sicherungsvorrichtung (11), (12), (13) in dem Gehäuse (10) vorgesehen ist, welche die Übertragung des elektrischen Signals im Falle eines Stromflusses, der über einem vorgegebenen Stromstärkewert liegt, unterbricht,
**dadurch gekennzeichnet,**
**dass** das Gehäuse (10) die opto-elektronische Vorrichtung (1) umgebungsseitig begrenzt, wobei das Gehäuse (10) aus einer Vergussmasse besteht, in welche die Sicherungsvorrichtung (11, 12, 13), die optische Sendeeinheit (25) und die optische Empfangseinheit (24) eingebettet sind, wobei das Gehäuse in dem die Bauteile angeordnet sind vollständig aus der Vergussmasse besteht,
wobei wenigstens zwei elektrische Anschlüsse (51), (52), (53) an dem Gehäuse (10) zur Herstellung einer ersten elektrischen Verbindung mit dem Eingangsstromkreis (3) vorgesehen sind und
**dass** wenigstens zwei weitere elektrische Anschlüsse (61), (62), (63) an dem Gehäuse (10) zur Herstellung einer zweiten elektrischen Verbindung mit dem Ausgangsstromkreis (5) vorgesehen sind.

2. Opto-elektronische Vorrichtung nach Anspruch 1,
**dadurch gekennzeichnet,**
**dass** die Sicherungsvorrichtung (11), (12), (13) den Eingangsstromkreis (3) oder den Ausgangsstromkreis (5) im Falle eines Stromflusses, der über einem vorgegebenen Stromstärkewert liegt, unterbricht

3. Opto-elektronische Vorrichtung nach Anspruch 1 oder 2,
**dadurch gekennzeichnet,**
**dass** es sich bei der Sicherungsvorrichtung (11), (12), (13) um eine elektrische, elektronische oder thermische Sicherungsvorrichtung (11), (12), (13) handelt.

4. Opto-elektronische Vorrichtung nach einem der vorherigen Ansprüche,
**dadurch gekennzeichnet,**
**dass** die Sicherungsvorrichtung (11), (12), (13) so ausgelegt und auf das Gehäuse (10) und/oder die Vergussmasse abgestimmt ist,
**dass** im Fall einer etwaigen durch das Auslösen der Sicherungsvorrichtung (11), (12), (13) verursachten Beschädigung des Gehäuses (10) und/oder der Vergussmasse,
die optische Sendeeinheit (25) oder die optische Empfangseinheit (24) wenigstens teilweise von dem Gehäuse (10) umgeben und/oder in der Vergussmasse eingebettet ist.

5. Opto-elektronische Vorrichtung nach einem der vorherigen Ansprüche,
**dadurch gekennzeichnet,**
**dass** die Sicherungsvorrichtung (11), (12), (13) einen solchen Abstand zur optischen Sendeeinheit (25) und/oder zur optischen Empfangseinheit (24) aufweist,
**dass** im Fall einer etwaigen durch das Auslösen der Sicherungsvorrichtung (11), (12), (13) verursachten Beschädigung des Gehäuses (10) oder der Vergussmasse,
die optische Sendeeinheit (25) oder die optische Empfangseinheit (24) wenigstens teilweise von dem Gehäuse (10) umgeben und/oder in der Vergussmasse eingebettet ist.

6. Opto-elektronische Vorrichtung nach einem der vorherigen Ansprüche,
**dadurch gekennzeichnet,**
**dass** der Eingangsstromkreis (3) mindestens eine erste Sicherungsvorrichtung (11) enthält, welche in dem Gehäuse (10) angeordnet ist und
**dass** der Ausgangsstromkreis mindestens eine zweite Sicherungsvorrichtung (12, 13) enthält, welche in dem Gehäuse angeordnet ist.

7. Opto-elektronische Vorrichtung nach Anspruch 6,
**dadurch gekennzeichnet,**
**dass** die erste Sicherungsvorrichtung (11) in Reihe zu der optischen Sendeeinheit (25) angeordnet ist und/oder
**dass** die zweite Sicherungsvorrichtung (12), (13) in Reihe zu der optischen Empfangseinheit (24) angeordnet ist.

8. Opto-elektronische Vorrichtung nach Anspruch 6 oder 7,
**dadurch gekennzeichnet,**
**dass** die erste Sicherungsvorrichtung (11) einen Abstand zu der zweiten Sicherungsvorrichtung (12), (13) aufweist, der größer ist als der Abstand der optischen Sendeeinheit (25) zur optischen Empfangseinheit (24).

9. Opto-elektronische Vorrichtung nach einem der vorherigen Ansprüche,
**dadurch gekennzeichnet,**
**dass** das Gehäuse in verschiedene Gehäuseabschnitte unterteilt ist, die bspw. die Sendeeinheit und/oder die Empfangseinheit oder die Sicherungsvorrichtung enthalten, wobei diese Gehäuseabschnitte bspw. mittels einer Sollbruchstelle miteinander verbunden sind.

10. Verwendung einer opto-elektronischen Vorrichtung (1) nach einem der Ansprüche 1 bis 9 in einem Messgerät der Prozessautomatisierungstechnik zur Bestimmung und/oder Überwachung einer chemischen und/oder physikalischen Messgröße.

## Claims

1. Optoelectronic unit (1) designed to transmit an electrical signal from an input circuit (3) to an output circuit (5) which is galvanically isolated from the input circuit (3),
with a housing (10),
wherein the input circuit (3) contains an optical transmission unit (25) for the generation of an optical signal, said unit being arranged in the housing (10),
wherein the output circuit (5) contains an optical receiver unit (24) for receiving the optical signal, said unit being arranged in the housing (10),
wherein at least one safety device (11), (12), (13) is provided in the housing (10), said safety device interrupting the transmission of the electrical signal in the event of a current flow that is over a pre-specified current strength value,
**characterized in that**
the housing (10) delimits the optoelectronic unit (1) on the environment side, said housing (10) consisting of a potting compound in which the safety device (11), (12), (13), the optical transmission unit (25) and the optical receiver unit (24) are embedded, wherein the housing in which the components are arranged consist completely of the potting compound,
wherein at least two electrical connections (51), (52), (53) are provided on the housing (10) to create a first electrical connection with the input circuit (3), and
**in that** at least two other electrical connections (61), (62), (63) are provided on the housing (10) to create a second electrical connection with the output circuit (5).

2. Optoelectronic unit as claimed in Claim 1,
**characterized in that**
the safety device (11), (12), (13) interrupts the input circuit (3) or the output circuit (5) in the event of current flow that is above a pre-specified current strength value.

3. Optoelectronic unit as claimed in Claim 1 or 2,
**characterized in that**
the safety device (11), (12), (13) is an electrical, electronic or thermal safety device (11), (12), (13).

4. Optoelectronic unit as claimed in one of the previous claims,
**characterized in that**
the safety device (11), (12), (13) is designed and adapted to the housing (10) and/or the potting compound in such a way that in the event of any damage to the housing (10) and/or the potting compound caused by the triggering of the safety device (11), (12), (13), the optical transmission unit (25) or the optical receiver unit (24) is at least partially surrounded by the housing (10) and/or embedded in the potting compound.

5. Optoelectronic unit as claimed in one of the previous claims,
**characterized in that**
the safety device (11), (12), (13) is at such a distance from the optical transmission unit (25) and/or the optical receiver unit (24)
that in the event of any damage to the housing (10) or the potting compound caused by the triggering of the safety device (11), (12), (13), the optical transmission unit (25) or the optical receiver unit (24) is at least partially surrounded by the housing (10) and/or embedded in the potting compound.

6. Optoelectronic unit as claimed in one of the previous claims,
**characterized in that**
the input circuit (3) contains at least a first safety device (11) which is arranged in the housing (10), and
**in that** the output circuit (5) contains at least a second safety device (12), (13) which is arranged in the housing (10)

7. Optoelectronic unit as claimed in Claim 6,
**characterized in that**
the first safety device (11) is arranged in series in relation to the optical transmission unit (25) and/or
**in that** the second safety device (12), (13) is arranged in series in relation to the optical receiver unit (24).

8. Optoelectronic unit as claimed in Claim 6 or 7,
**characterized in that**
the first safety device (11) is at a distance from the second safety device (12), (13) that is greater than the distance between the optical transmission unit (25) and the optical receiver unit (24).

9. Optoelectronic unit as claimed in one of the previous claims,
**characterized in that**
the housing is divided into different housing sections that, for example, contain the transmission unit and/or the receiver unit or the safety device, wherein these housing sections are interconnected via a predetermined breaking point, for instance.

10. Use of an optoelectronic unit (1) as claimed in one of the Claims 1 to 9 in a measuring device used in process automation engineering for determining and/or monitoring a chemical and/or physical variable.

## Revendications

1. Dispositif optoélectronique (1) destiné à la transmission d'un signal électrique d'un circuit d'entrée (3) à un circuit de sortie (5) séparé galvaniquement du circuit d'entrée (3), avec un boîtier (10),
pour lequel le circuit d'entrée (3) contient une unité d'émission optique (25) pour la génération d'un signal optique, laquelle est disposée dans le boîtier (10),
pour lequel le circuit de sortie (5) contient une unité de réception optique (24) pour la réception d'un signal optique, laquelle est disposée dans le boîtier (10),
pour lequel est prévu dans le boîtier (10) au moins un dispositif de sécurité (11), (12), (13), qui interrompt la transmission du signal électrique en cas de flux de courant dépassant une valeur d'intensité prédéfinie,
**caractérisé en ce**
**que** le boîtier (10) limite le dispositif optoélectronique (1) côté environnement, le boîtier (10) étant constitué d'une masse de scellement, dans laquelle sont intégrés le dispositif de sécurité (11), (12), (13), l'unité d'émission optique (25) et l'unité de réception optique (24), le boîtier dans lequel les composants sont disposés étant constitué intégralement d'une masse de scellement,
au moins deux connexions électriques (51), (52), (53) étant prévues sur le boîtier (10) pour l'établissement d'une première liaison électrique avec le circuit d'entrée (3), et
en ce qu'au moins deux connexions électriques supplémentaires (61), (62), (63) sont prévues sur le boîtier (10) pour l'établissement d'une deuxième liaison électrique avec le circuit de sortie (3).

2. Dispositif optoélectronique selon la revendication 1,
**caractérisé en ce**
**que** le dispositif de sécurité (11), (12), (13) interrompt le circuit d'entrée (3) ou le circuit de sortie (5) en cas de flux de courant dépassant une valeur d'intensité prédéfinie.

3. Dispositif optoélectronique selon la revendication 1 ou 2,
**caractérisé en ce**
**que**, concernant le dispositif de sécurité (11), (12), (13), il s'agit d'un dispositif de sécurité (11), (12), (13) électrique, électronique ou thermique.

4. Dispositif optoélectronique selon l'une des revendications précédentes,
**caractérisé en ce**
**que** le dispositif de sécurité (11), (12), (13) est conçu et assorti au boîtier (10) et/ou à la masse de scellement de telle sorte qu'en cas d'éventuel endommagement du boîtier (10) et/ou de la masse de scellement occasionné par le déclenchement du dispositif de sécurité (11), (12), (13), l'unité d'émission optique (25) ou l'unité de réception (24) est entourée au moins partiellement par le boîtier (10) et/ou intégrée dans la masse de scellement.

5. Dispositif optoélectronique selon l'une des revendications précédentes,
**caractérisé en ce**
**que** le dispositif de sécurité (11), (12), (13) présente par rapport à l'unité d'émission optique (25) et/ou l'unité de réception optique (24) une distance telle
**qu'**en cas d'éventuel endommagement du boîtier (10) et/ou de la masse de scellement occasionné par le déclenchement du dispositif de sécurité (11), (12), (13), l'unité d'émission optique (25) ou l'unité de réception (24) est entourée au moins partiellement par le boîtier (10) et/ou intégrée dans la masse de scellement

6. Dispositif optoélectronique selon l'une des revendications précédentes,
**caractérisé en ce**
**que** le circuit d'entrée (3) contient au moins un premier dispositif de sécurité (11), lequel est disposé dans le boîtier (10), et
en ce que le circuit de sortie (5) contient au moins un deuxième dispositif de sécurité (12), (13), lequel est disposé dans le boîtier (10)

7. Dispositif optoélectronique selon la revendication 6,
**caractérisé en ce**
**que** le premier dispositif de sécurité (11) est disposé en série avec l'unité d'émission optique (25) et/ou
en ce que le deuxième dispositif de sécurité (12), (13) est disposé en série avec l'unité de réception optique (24).

8. Dispositif optoélectronique selon la revendication 6 ou 7,
**caractérisé en ce**
**que** le dispositif de sécurité (11) présente une distance par rapport au deuxième dispositif de sécurité (12), (13), qui est supérieure à la distance de l'unité d'émission optique (25) par rapport à l'unité de réception optique (24).

9. Dispositif optoélectronique selon l'une des revendications précédentes,
**caractérisé en ce**
**que** le boîtier est scindé en plusieurs parties, qui contiennent par exemple l'unité d'émission et/ou l'unité de réception ou le dispositif de sécurité, ces parties de boîtier étant reliées entre elles, par exemple, au moyen d'un point destiné à la rupture.

10. Utilisation d'un dispositif optoélectronique (1) selon l'une des revendications 1 à 9 dans un appareil de mesure de la technique d'automatisation des process, destiné à la détermination et/ou la surveillance d'une grandeur de mesure chimique et/ou physique.
